Europäisches Patentamt

European Patent Office

Office européen des brevets

(11) Publication number: **0 216 380 B1**

# EUROPEAN PATENT SPECIFICATION

(45) Date of publication of patent specification: **27.11.91**   (51) Int. Cl.⁵: **H01L 29/06**, H01L 29/72, H01L 29/90

(21) Application number: **86113188.6**

(22) Date of filing: **25.09.86**

(54) **Semiconductor device with a field plate electrode structure.**

(30) Priority: **26.09.85 JP 212852/85**

(43) Date of publication of application:
**01.04.87 Bulletin 87/14**

(45) Publication of the grant of the patent:
**27.11.91 Bulletin 91/48**

(84) Designated Contracting States:
**DE FR GB**

(56) References cited:
**FR-A- 2 345 814**
**FR-A- 2 389 236**
**US-A- 3 959 812**

(73) Proprietor: **KABUSHIKI KAISHA TOSHIBA**
**72, Horikawa-cho Saiwai-ku**
**Kawasaki-shi Kanagawa-ken(JP)**

(72) Inventor: **Kimura, Akihiro c/o Patent Div.**
**Toshiba K.K.**
**1-1 Shibaura 1-chome**
**Minato-ku Tokyo(JP)**
Inventor: **Kamasaki, Keiji c/o Patent Div.**
**Toshiba K.K.**
**1-1 Shibaura 1-chome**
**Minato-ku Tokyo(JP)**

(74) Representative: **Lehn, Werner, Dipl.-Ing. et al**
**Hoffmann, Eitle & Partner Patentanwälte Arabellastrasse 4**
**W-8000 München 81(DE)**

## Description

The present invention relates to an improvement of a semiconductor device, such as a diode, a transistor, thyristor, and the like, which can have a high breakdown voltage by adopting a field plate electrode structure such as described in US-A-39 59812.

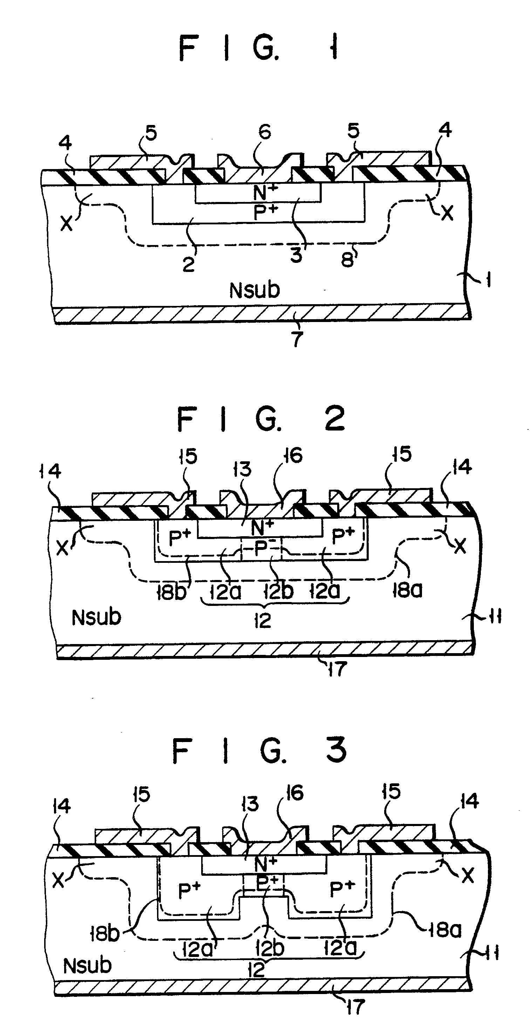

Fig. 1 shows a high-breakdown voltage npn bipolar transistor having a conventional field plate electrode structure. Referring to Fig. 1, $p^+$-type base region 2 is formed in a major surface of n-type silicon substrate 1, and $n^+$-type emitter region 3 is formed in base region 2. Oxide film 4 is formed on the major surface of substrate 1, and portions of oxide film 4 on base and emitter regions 2 and 3 are etched to form a contact hole. Base electrode 5 contacts base region 2 and emitter electrode 6 contacts emitter region 3 through the contact hole. Base electrode 5 contacts base region 2, and extends on oxide film 4 by a predetermined distance toward outside of the semiconductor device beyond the upper end of the p-n junction between substrate 1 and base region 2, thus forming a field plate electrode structure. In addition, collector electrode 7 is formed on the back surface of substrate 1.

In the bipolar transistor with the above field plate electrode structure, when a negative voltage is applied to base electrode (field plate electrode) 5 or emitter electrode 6 and a positive voltage is applied to collector electrode 7, depletion layer 8 which is formed at a p-n junction between collector region 1 and base region 2 (indicated by a broken curve in Fig. 1) extends below the extending portion of base electrode (field plate electrode) 5. For this reason, electric field concentration does not easily occur when compared with a case wherein a base electrode is not extended. Therefore, when the semiconductor device with the field plate electrode structure has a small diffusion depth, for example, even if the diffusion depth of base region 2 is about 5μm, if substrate 1 has a specific resistance of several tens of Ω • cm, a high breakdown voltage of 500 V or higher can be obtained.

Such an improvement of breakdown voltage can be applied not only to a transistor but also to other semiconductor devices such as a diode, a thyristor, and the like.

As described above, in the semiconductor device with the field plate electrode structure, since depletion layer 8 extends below the field plate electrode, a high breakdown voltage can be obtained. However, an electric field strength becomes maximum immediately below the end of the field plate electrode (indicated by X in Fig. 1), and breakdown occurs in this portion. If a large current flows during breakdown, substrate 1 causes crystal destruction (breakover destruction) and cannot often be reused.

The present invention has been made to eliminate the above drawback, and has as its object to provide a semiconductor device which adopts a field plate electrode structure to obtain a high breakdown voltage with a relatively small diffusion depth and will not cause breakover destruction.

The object of the present invention, is solved by providing a semiconductor device in accordance with Claim 1.

As the means for starting breakdown due to punchthrough in the diffusion layer of the second conductivity type, the diffusion layer of the second conductivity type comprises a high impurity concentration region and a low impurity concentration region, so that the diffusion layer of the first conductivity type forms a p-n junction with the low impurity concentration region constituting the diffusion layer of the second conductivity type. With this structure, since the depletion layer can easily extend from a low-concentration diffusion layer constituting the diffusion layer of the second conductivity type toward the diffusion layer of the first conductivity type, punch-through easily occurs between the low-concentration diffusion layer and the diffusion layer of the first conductivity type. The impurity concentration of the low-concentration diffusion layer is appropriately selected so that punch-through occurs at a voltage lower than a voltage causing breakdown immediately below the end of the field plate.

Alternatively, the diffusion layer of the second conductivity type is constituted by regions of large and small diffusion depths, the large diffusion depth region having the high impurity concentration, and the small diffusion depth region having the low impurity concentration. The diffusion layer of the first conductivity type forms a p-n junction with the region having the small diffusion depth and low impurity concentration and constituting the diffusion layer of the second conductivity type. With this structure, a depletion layer can be easily extended from the region having the small diffusion depth and low impurity concentration toward the diffusion layer of the first conductivity type. Since the distance to the diffusion layer of the first conductivity type is small, punch-through easily occurs between the region having the small diffusion depth and low impurity concentration and the diffusion layer of the first conductivity type. The diffusion depth and the impurity concentration of the region having the small diffusion depth and low impurity concentration is appropriately selected so that punch-through occurs at a voltage lower than a voltage causing breakdown immediately below the end of a field plate.

According to the above semiconductor devices, since breakdown is caused by punch-through between the diffusion layers of the first and second conductivity types, breakdown immediately below an electrode (field plate) can be prevented, and a substrate can be protected from crystal destruction.

This invention can be more fully understood from the following detailed description when taken in conjunction with the accompanying drawings, in which:

Fig. 1 is a sectional view of a high breakdown voltage bipolar transistor of a conventional field plate electrode structure;

Figs. 2 and 4 are sectional views of a high breakdown voltage bipolar transistor of a field plate electrode structure according to the present invention;

Figs. 3 is a sectional view of a high breakdown voltage bipolar transistor of a field plate electrode structure outside the scope of the present invention;

Figs. 5 and 7 are sectional views of a high breakdown voltage diode of a field plate electrode structure outside the scope of the present invention; and

Figs. 6 and 8 are sectional views of high breakdown voltage diodes of a field plate electrode structure according to the present invention.

The present invention will be described by way of its examples.

Example 1

Fig. 2 is a sectional view of an npn bipolar transistor with a field plate electrode structure. Referring to Fig. 2, base region 12 serving as a first diffusion region is formed in a major surface of n-type silicon substrate 11. The diffusion depth of base region 12 is about $5\mu m$, and region 12 is constituted by $p^+$-type diffusion layer 12a having a surface concentration of about $1 \times 10^{18}$ $cm^{-3}$, and $p^-$-type diffusion layer 12b having a surface concentration of about $5 \times 10^{16}$ $cm^{-3}$. $N^+$-type emitter region 13 is formed in base region 12 to form a p-n junction with $p^-$-type diffusion layer 12b. Oxide film 14 is formed on the major surface of substrate 11. Portions of oxide film 14 on diffusion layer 12a constituting base region 12 and on emitter region 13 are etched to form a contact hole. Base electrode 15 contacts base region 12 and emitter electrode 16 contacts emitter region 13 through the contact hole. Base electrode 15 contacts base region 12, and extends outward on oxide film 14 by a predetermined distance beyond the upper end of the p-n junction between substrate 11 and base region 12, thus forming a field plate electrode structure. In addition, collector electrode 17 is formed on the back surface of substrate 11.

In the bipolar transistor shown in Fig. 2, when a negative voltage is applied to base electrode 15 or emitter electrode 16 and a positive voltage is applied to collector electrode 17, a depletion layer is formed in a p-n junction between substrate 11 and base region 12. More specifically, depletion layer 18a extends toward substrate 11 and depletion layer 18b extends toward base region 12. Depletion layer 18b at the side of base region 12 does not significantly extend in diffusion layer 12a constituting base region 12 but considerably extends in diffusion layer 12b. Therefore, depletion layer 18b in diffusion layer 12b easily reaches emitter region 13. As a result, punch-through occurs between layer 12b and region 13. The impurity concentration of diffusion layer 12b constituting base region 12 is selected so that a voltage causing punch-through is lower than a voltage causing breakdown in a portion immediately below base electrode (field plate electrode) 15 (indicated by X in Fig. 2). Thus, breakdown is caused by punch-through between base region 12 and emitter region 13, i.e., in the first diffusion region. Therefore, crystal destruction of substrate 11 immediately below base electrode (field plate electrode) 15 can be prevented.

Fig. 3 shows an example outside the present invention. In this example, diffusion layers 12a and 12b constituting base region 12 have different diffusion depths. Layer 12a is formed to be deep, and layer 12b is formed to be shallow. Note that in this example, layers 12a and 12b are high-concentration $p^+$-type diffusion layers. Other structural details are essentially the same as those in the example shown in Fig. 2. The same reference numerals in Fig. 3 denote the same portions as in Fig. 2, and a detailed description thereof will be omitted.

In the bipolar transistor shown in Fig. 3, when a negative voltage is applied to base electrode 15 or emitter electrode 16 and a positive voltage is applied to collector electrode 17, a depletion layer is formed in a p-n junction between substrate 11 and base region 12. More specifically, depletion layer 18a extends toward substrate 11 and depletion layer 18b extends toward base region 12. Since diffusion layer 12b is formed to be shallow, the depletion layer in layer 12b easily reaches emitter region 13. As a result, punch-through occurs between layer 12b and emitter region 13. The diffusion depth of diffusion layer 12b is selected so that a voltage causing punch-through is lower than a voltage causing breakdown in a portion immediately below the end of base electrode (field plate electrode) 15 (indicated by X in Fig. 3). Breakdown is initiated due to punch-through between layer 12b and emitter region 13, i.e., in the first diffusion region. Therefore, crystal destruction of substrate 11 immediately below the end of base electrode (field plate electrode) 15 can be prevented.

Example 2

Fig. 4 shows a second example of the present invention. In this example, base region 12 is constituted by p$^+$-type diffusion layer 12a having a surface concentration of about $1 \times 10^{18}$ cm$^{-3}$ and p$^-$-type diffusion layer 12b having a surface concentration of about $5 \times 10^{16}$ cm$^{-3}$. Layers 12a and 12b have different diffusion depths so that layer 12a is formed to be deep, e.g., about 5$\mu$m, and layer 12b is formed to be shallow.

Other structural details are essentially the same as those in the examples shown in Figs. 2 and 3. The same reference numerals in Fig. 4 denote the same portions in Figs. 2 and 3, and a detailed description thereof will be omitted.

In the bipolar transistor shown in Fig. 4, when a negative voltage is applied to base electrode 15 or emitter electrode 16 and a positive voltage is applied to collector electrode 17, a depletion layer is formed in a p-n junction between substrate 11 and base region 12. More specifically, depletion layer 18a extends toward substrate 11 and depletion layer 18b extends toward base region 12. Since diffusion layer 12b comprises a low impurity concentration region, the depletion layer extends considerably in layer 12b. In addition, since layer 12b is formed to be shallow, the depletion layer in layer 12b can easily reach region 13. As a result, punch-through occurs between layer 12b and emitter region 13. The diffusion depth and/or the impurity concentration of diffusion layer 12b constituting base region 12 is selected so that a voltage causing punch-through is lower than a voltage causing breakdown in a portion immediately below the end of base electrode (field plate electrode) 15 (indicated by X in Fig. 4). Thus, breakdown is caused by punch-through between layer 12b and emitter region 13, i.e., in the first diffusion region. Therefore, crystal destruction of substrate 11 immediately below the end of base electrode (field plate electrode) 15 can be prevented.

Example 3

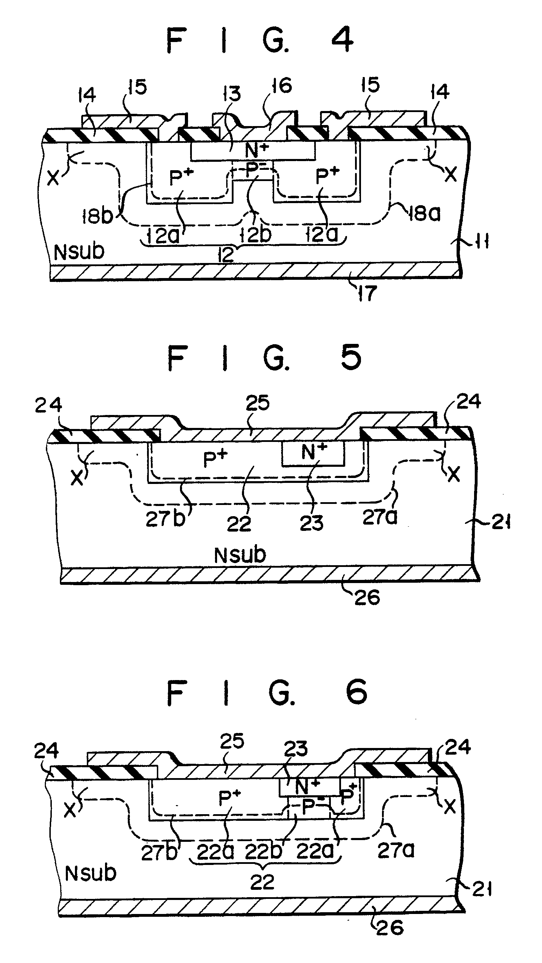

Fig. 5 is a sectional view of a diode with a field plate electrode structure outside the present invention. Referring to Fig. 5, p-type diffusion layer 22 serving as a first diffusion region is formed in the major surface of n-type silicon substrate 21. N-type diffusion layer 23 for causing punch-through is formed in diffusion layer 22. Oxide film 24 is formed on the major surface of substrate 21, and portions thereof on diffusion layers 23 and 22 are etched to form a contact hole. Electrode (field plate electrode) 25 contacting diffusion layers 22 and 23 through the contact hole is formed. Electrode 25 extends outward by a predetermined distance on oxide film 24 beyond the upper end of the p-n junction between substrate 21 and diffusion layer 22, thus forming a field plate electrode structure. In addition, rear electrode 26 is formed on the back surface of substrate 21.

Fig. 6 shows example 3 of the present invention which is a modification of Fig. 5. P-type diffusion layer 22 is constituted by high concentration p$^+$-type diffusion layer 22a and low concentration p$^-$-type diffusion layer 22b, so that layer 22b forms a p-n junction with layer 23. Other structural details are the same as those in the diode shown in Fig. 5.

Example 4

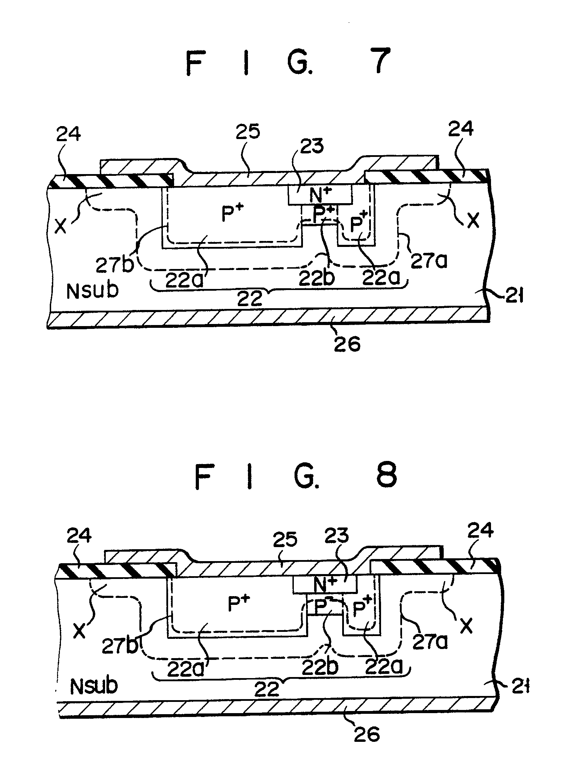

Fig. 7 shows another modification of Fig. 5 outside the present invention. Diffusion layers 22a and 22b constituting diffusion layer 22 have different diffusion depths so that layer 22a is diffused relatively deep and layer 22b is diffused relatively shallow. Other structural details are the same as those in the diode shown in Fig. 5.

Fig. 8 shows example 4 of the present invention which is a modification of Figs. 6 and 7. p$^+$-type and p$^-$-type diffusion layers 22a and 22b constituting p-type diffusion layer 22 are diffused relatively deep and relatively shallow, respectively. Other structural details are the same as those in the diodes shown in Figs. 6 and 7.

In the diodes shown in Figs. 6 and 8, when a negative voltage is applied to electrode 25 and a positive voltage is applied to back-surface electrode 26, a depletion layer is formed in a p-n junction between substrate 21 and p-type diffusion layer 22. Depletion layer 27a extends toward substrate 21 and depletion layer 27b extends toward layer 22. When depletion layer 27b at the side of diffusion layer 22 further extends, it reaches diffusion layer 23, and punch-through occurs, thereby causing breakdown.

Since a voltage causing punch-through is set to be lower than a voltage causing breakdown in portion immediately below the end of electrode (field plate electrode) 25, breakover destruction can be prevented, and substrate 21 immediately below the end of electrode (field plate electrode) 25 can be protected from crystal destruction.

In the structure shown in Fig. 6, since diffusion layer 22 is constituted by p$^+$-type diffusion layer 22a and p$^-$-type diffusion layer 22b, depletion layer 27b does not significantly extend in layer 22a but considerably extends in layer 22b. Punch-through easily occurs between layers 22b and 23. In this manner, a voltage causing punch-through can be controlled by changing the impurity concentration of diffusion layer 22.

In the structure shown in Fig. 8, a voltage causing punch-through can be controlled not only by the impurity concentrations of diffusion layers 22a and 22b constituting diffusion layer 22 but also by the diffusion depths of these diffusion layers.

According to the present invention as described above, a long-life semiconductor device which adopts a field plate electrode structure to obtain a high breakdown voltage with a relatively small diffusion depth and will not cause breakover destruction can be provided.

## Claims

1. A semiconductor device with a field plate electrode structure comprising:

   a first semiconductor diffusion layer (12,22) of a second conductivity type formed in a major surface of a semiconductor substrate (11,21) of a first conductivity type said first semiconductor diffusion layer (12,22) including a high impurity concentration region (12a,22a) and a low impurity concentration region (12b,22b), said regions (12a,12b;22a,22b) forming a p-n junction with said substrate (11,21);

   a second semiconductor diffusion layer (13,23) of the first conductivity type formed in said first semiconductor diffusion layer (12,22) of the second conductivity type and forming a p-n junction between the second semiconductor diffusion layer (13,23) and said regions (12a,12b;22a,22b) of said first semiconductor diffusion layer (12,22) of the second conductivity type;

   an insulating film (14,24) formed on the major surface of said substrate (11,21);

   an electrode (15,25) contacting at least said first semiconductor diffusion layer (12,22) of the second conductivity type through an opening formed in said insulating film (14,24), extending outward on said insulating film (14,24) by a predetermined length beyond an upper end of said p-n junction between said substrate (11,21) and said first semiconductor diffusion layer (12,22) of the second conductivity type and forming the field plate type electrode,

   wherein

   said low impurity concentration region (12b,22b) of said first semiconductor diffusion layer (12,22) is in contact with only a portion of the bottom of said second semiconductor diffusion layer (13,23) and extends to the semiconductor substrate (11,21), the impurity concentration of said low impurity concentration region (12b,22b) being selected so that punch through when caused by a high reverse voltage between said substrate (11,21) and said first semiconductor diffusion region (12,22) occurs in said contact portion and at a voltage lower than a voltage causing breakdown immediately below the end of the field plate type electrode.

2. A semiconductor device according to claim 1, **characterized** in that said electrode (15,25) commonly contacts the first semiconductor diffusion layer of the second conductivity type and said second semiconductor diffusion layer of the first conductivity type.

3. A semiconductor device according to claim 1 or 2 **characterized** in that said high impurity concentration region (12a,22a) comprises a deep region (12a,22a), and said low impurity concentration region (12b,22b) comprises a shallow region (12b,22b).

## Revendications

1. Un dispositif à semiconducteurs comportant une structure d'électrode à plaque de champ, comprenant :

   une première couche de diffusion en semiconducteur (12, 22) d'un second type de conductivité, formée dans une surface principale d'un substrat semiconducteur (11, 21) d'un premier type de conductivité, cette première couche de diffusion en semiconducteur (12, 22) comprenant une région à concentration en impureté élevée (12a, 22a) et une région à faible concentration en impureté (12b, 22b), ces régions (12a, 12b; 22a, 22b) formant une jonction p-n avec le substrat (11, 21);

   une seconde couche de diffusion en semiconducteur (13, 23) du premier type de conductivité, formée dans la première couche de diffusion en semiconducteur (12, 22) du second type de conductivité, et formant une jonction p-n entre la seconde couche de diffusion en semiconducteur (13, 23) et les régions précitées (12a, 12b; 22a, 22b) de la première couche de diffusion en semiconducteur (12, 22) du second type de conductivité;

   une pellicule isolante (14, 24) formée sur la surface principale du substrat (11, 21);

   une électrode (15, 25) venant en contact au moins avec la première couche de diffusion en semiconducteur (12, 22) du second type de conductivité, par l'intermédiaire d'une ouverture qui est formée dans la pellicule isolante (14, 24), s'étendant vers l'extérieur sur la pellicule isolante (14, 24) sur une longueur prédéterminée, au-delà d'une extrémité supérieure de la jonction p-n entre le substrat (11, 21) et la première couche de diffusion en semiconducteur (12, 22) du second type de conductivité, et formant l'électrode de type plaque de champ,

dans lequel la région à faible concentration en impureté (12b, 22b) de la première couche de diffusion en semiconducteur (12, 22) est en contact avec seulement une partie de la surface inférieure de la seconde couche de diffusion en semiconducteur (13, 23), et elle s'étend jusqu'au substrat semiconducteur (11, 21), la concentration en impureté de la région à faible concentration en impureté (12b, 22b) étant sélectionnée de façon que lorsqu'un phénomène de pénétration est occasionné par une tension inverse élevée entre le substrat (11, 21) et la première région de diffusion en semiconducteur (12, 22), ce phénomène de pénétration se produise dans la partie de contact précitée, et à une tension inférieure à une tension qui occasionne un claquage immédiatement au-dessous de l'extrémité de l'électrode de type plaque de champ.

2. Un dispositif à semiconducteurs selon la revendication 1, caractérisé en ce que l'électrode précitée (15, 25) vient en contact en commun avec la première couche de diffusion en semiconducteur du second type de conductivité et avec la seconde couche de diffusion en semiconducteur du premier type de conductivité.

3. Un dispositif à semiconducteurs selon la revendication 1 ou 2, caractérisé en ce que la région à concentration en impureté élevée (12a, 22a) consiste en une région profonde (12a, 22a), et la région à faible concentration en impureté (12b, 22b) consiste en une région superficielle (12b, 22b).

**Patentansprüche**

1. Halbleiteranordnung mit einer Feldplattenelektrodenstruktur mit:

einer ersten Halbleiterdiffusionsschicht (12, 22) eines zweiten Leitfähigkeitstyps, die in einer Hauptoberfläche eines Halbleitersubstrats (11, 21) eines ersten Leitfähigkeitstyps ausgebildet ist, wobei die erste Halbleiterdiffusionssicht (12, 22) einen Bereich (12a, 22a) hoher Verunreinigungskonzentration und einen Bereich (12b, 22b) geringer Verunreinigungskonzentration umfaßt, wobei die Bereiche (12a, 12b; 22a, 22b) einen p-n-Übergang mit dem Substrat (11, 21) ausbilden;

einer zweiten Halbleiterdiffusionssicht (13, 23) des ersten Leitfähigkeitstyps, die in der ersten Halbleiterdiffusionsschicht (12, 22) des zweiten Leitfähigkeitstyps ausgebildet ist und die einen p-n-Übergang zwischen der zweiten Halbleiterdiffusionsschicht (13, 23) und den Bereichen (12a, 12b; 22a, 22b) der ersten Halbleiterdiffusionssicht (12, 22) des zweiten Leitfähigkeitstyps ausbildet;

einem Isolierfilm (14, 24), der auf der Hauptoberfläche des Substrats (11, 21) ausgebildet ist;

eine Elektrode (15, 25), die zumindest die erste Halbleiterdiffusionssicht (12, 22) des zweiten Leitfähigkeitstyps durch eine Öffnung kontaktiert, die in dem Isolierfilm (14, 24) ausgebildet ist, die sich auswärts auf dem Isolierfilm (14, 24) über eine vorbestimmte Länge über ein oberes Ende des p-n-Übergangs zwischen dem Substrat (11, 21) und der ersten Halbleiterdiffusionssicht (12, 22) des zweiten Leitfähigkeitstyps erstreckt und die Feldplattentypelektrode bildet,

bei der der Bereich (12b, 22b) geringer Verunreinigungskonzentration der ersten Halbleiterdiffusionsschicht (12, 22) in Kontakt mit nur einem Abschnitt des Bodens der zweiten Halbleiterdiffusionsschicht (13, 23) ist, und sich zu dem Halbleitersubstrat (11, 21) erstreckt, wobei die Verunreinigungskonzentration des Bereichs (12b, 22b) geringer Verunreinigungskonzentration derart ausgewählt ist, daß Durchgreifen, wenn es durch eine hohe Spannung in Rückwärtsrichtung zwischen dem Substrat (11, 21) und der ersten Halbleiterdiffusionsschicht (12, 22) bewirkt wird, auftritt in dem Kontaktabschnitt und bei einer Spannung, die geringer ist als eine Spannung, die einen Durchbruch unmittelbar unter dem Ende der Feldplattentypelektrode bewirkt.

2. Halbleiteranordnung nach Anspruch 1, dadurch **gekennzeichnet,** daß die Elektrode (15, 25) gemeinsam die erste Halbleiterdiffusionsschicht des zweiten Leitfähigkeitstyps und die zweite Halbleiterdiffusionssicht des ersten Leitfähigkeitstyps kontaktiert.

3. Halbleiteranordnung nach Anspruch 1 oder 2, dadurch **gekennzeichnet,** daß der Bereich (12a, 22a) hoher Verunreinigungskonzentration einen tiefen Bereich (12a, 22a) umfaßt und daß der Bereich (12b, 22b) geringer Verunreinigungskonzentration einen flachen Bereich (12b, 22b) umfaßt.

# F I G. 1

N+

P+

X          X

2      3     8

Nsub                      1

7

# F I G. 2

N+

P+          P+

X          X

18b  12a  12b  12a      18a

Nsub                     11

12

17

# F I G. 3

N+

P+    P+    P+

X          X

18b                    18a

12a    12b    12a

Nsub                    11

12

17

# F I G. 4

# F I G. 5

# F I G. 6

# F I G. 7

# F I G. 8